Europäisches Patentamt

European Patent Office

Office européen des brevets

(19)

(11) **EP 1 400 456 A1**

(12) **EUROPEAN PATENT APPLICATION**
published in accordance with Art. 158(3) EPC

(43) Date of publication:
**24.03.2004 Bulletin 2004/13**

(21) Application number: **01941260.0**

(22) Date of filing: **26.06.2001**

(51) Int Cl.[7]: **B65D 1/00**, B65D 1/24,
B65D 25/04, B65D 25/34,
C08J 7/06, C23C 16/27,
C23C 16/511

(86) International application number:
**PCT/JP2001/005471**

(87) International publication number:
**WO 2003/000559 (03.01.2003 Gazette 2003/01)**

(84) Designated Contracting States:
**AT BE CH CY DE DK ES FI FR GB GR IE IT LI LU MC NL PT SE TR**
Designated Extension States:
**AL LT LV MK RO SI**

(71) Applicants:
• **MITSUBISHI SHOJI PLASTICS CORPORATION**
  **Shinagawa-ku, Tokyo 141-8535 (JP)**
• **Youtec Co. Ltd.**
  **Nagareyama-shi, Chiba 270-0156 (JP)**

(72) Inventors:
• **HAMA, Kenichi**
  **Shinagawa-ku, Tokyo 141-8535 (JP)**
• **KAGE, Tsuyoshi**
  **Shinagawa-ku, Tokyo 141-8535 (JP)**
• **KOBAYASHI, Takumi**
  **Nagareya ma-shi, Chiba 270-0156 (JP)**

(74) Representative:
**Bunke, Holger, Dr.rer.nat. Dipl.-Chem.**
**Prinz & Partner GbR**
**Manzingerweg 7**
**81241 München (DE)**

(54) **MANUFACTURING DEVICE FOR DLC FILM COATED PLASTIC CONTAINER; DLC FILM COATED PLASTIC CONTAINER&comma; AND METHOD OF MANUFACTURING THE DLC FILM COATED PLASTIC CONTAINER**

(57)     The present invention provides a manufacturing apparatus, a method of manufacturing a DLC film coated container and a DLC film coated container which make it possible to form a high-quality DLC film with good productivity on the outer wall surface or the inner wall surface of a container by a film forming mechanism obtained by effectively combining a high-frequency capacitive coupling type discharge system and a microwave discharge system which is different from the film forming mechanism of each method.

The manufacturing apparatus (100) of the present invention is an apparatus which forms a DLC film on the outer wall surface of a plastic container (1), and is equipped with a grounded vacuum chamber (2) for housing the plastic container (1), a high-frequency bias electrode (4) which is provided inside the vacuum chamber (2) via an insulating body (3) at a position in contact with the inner wall surface of the plastic container (1) or near the inner wall surface, a microwave supply means (10) which generates a source gas plasma inside the vacuum chamber (2) by introducing microwaves inside the vacuum chamber (2), a high-frequency output supply means (13) connected to the high-frequency bias electrode (4) to generate a self-bias voltage at the outer wall surface of the plastic container (1), and a source gas supply means (18) which introduces a source gas inside the vacuum chamber (2).

Fig.1

100

EP 1 400 456 A1

**Description**

## TECHNICAL FIELD

The present invention is related to an apparatus which forms a DLC (Diamond Like Carbon) film on the inner wall surface or the outer wall surface of a plastic container by a plasma CVD (Chemical Vapor Deposition) method, and in particular to an apparatus for manufacturing a DLC film coated plastic container which simultaneously uses high-frequency waves (RF) as ionization energy control means and microwaves (MW) as plasma density control means to make it possible to deposit a high-quality DLC film from the viewpoint of moisture and gas barrier properties at high speed. Further, the present invention is related to a method of manufacturing the DLC film coated plastic container described above, and a DLC film coated plastic container in which a DLC film is coated on the outer wall surface.

## PRIOR ART TECHNOLOGY

Japanese Laid-Open Patent Publication No. HEI 8-53117 discloses a film forming apparatus which uses a plasma CVD method to form a DLC film on the inner wall surface of a plastic container for the purpose of improving the gas barrier properties and the like of containers used as carbonated beverage and fruit juice containers and the like. This apparatus for manufacturing a DLC film coated plastic container is a high-frequency capacitive coupling type discharge system, and has the following characteristics. Namely, such system is equipped with a hollow-shaped external electrode having a space for housing a container in which the space forms a vacuum chamber and the external electrode is shaped roughly similar to the external shape of the container housed in the inner wall portion of the space, an insulating member which makes contact with the opening of a container and insulates the external electrode when the container is housed inside the space of the external electrode, a grounded internal electrode which is inserted from the opening of the container to the inside of the container housed inside the space of the external electrode, exhaust means which communicates inside the space of the external electrode to carry out exhaust inside the space, and supply means which supplies a source gas to the inside of the container housed inside the space of the external electrode, and a high-frequency power supply connected to the external electrode. In the publication described above, high-frequency waves are used as a plasma-generating energy source. The term high-frequency wave is a common expression, but in general is an electromagnetic wave in the range 100KHz ∼ 1000MHz. In the publication described above, there is no description of specific frequencies. Further, in general the high-frequency wave uses 13.56MHz which is an industrial frequency.

In the publication described above, after a vacuum of $10^{-2} \sim 10^{-5}$ torr is created inside the chamber, a source gas is introduced and the pressure is adjusted to 0.5 ∼ 0.001 torr, and then a high-frequency power of 50 ∼ 1000W, for example, is applied to form a DLC film on the inner wall surface of a plastic container. The film thickness of the DLC film is formed so as to be 0.05 ∼ 5μm.

On the other hand, WO99/49991 discloses an invention of a manufacturing apparatus which coats a DLC film on a plastic container using microwaves as a plasma-generating energy source. This apparatus is a microwave discharge system, and is characterized as being equipped with a space which becomes a vacuum chamber for housing a container, an external electrode, an insulating member which insulates the external electrode, exhaust means, source gas supply means and a microwave power supply. In the disclosure in this publication, when microwaves in the UHF range (300 ∼ 3000MHz), for example, 2.45GHz at several hundred W are applied, the microwaves pass through a waveguide and are introduced into the chamber. By using microwaves, there is no need for the internal electrode required in the invention of Japanese Laid-Open Patent Publication No. HEI 8-53117. At 0.01 ∼ 0.50 torr inside the chamber, a DLC film of 3000Å or less is formed on the inner wall surface or the outer wall surface of a container.

## SUMMARY OF THE INVENTION

However, the problems described below are not solved by the technology described above. Namely, generally in a high-frequency capacitive coupling type discharge system, the plasma density can not be raised after the plasma density reaches $10^9$ cm$^{-3}$, and the control of the plasma density and the control of the ionization energy can not be carried out independently. When the high-frequency waves are given a high output in order to raise the plasma density, many ionic collisions are created, and the etching effect is increased. Accordingly, in a high-frequency capacitive coupling type discharge system, the film forming rate can not be speeded up. For this reason, in the case where a DLC film is coated on a large-capacity container in a short time, the productive efficiency needs to be raised by separate means. Further, a self-bias voltage is generated on the plastic container wall surfaces due to the supplying of the high-frequency output, and this causes the source material converted to a plasma to be attracted to the plastic container wall surfaces, whereby ionic collisions occur. On the other hand with regard to obtaining a relatively fine DLC film, because the control of the ionization energy can not be carried out properly, there is a large number of ionic collisions, and this raises the temperature of the plastic and generates internal stress due to differential thermal expansion, whereby fine cracks are created. These fine cracks lower the moisture and gas barrier properties, and this causes the occurrence of film peeling due to washing of the plastic container.

On the other hand, in a microwave discharge system, because the plasma density can reach a high density of $10^{11} \sim 10^{12}$ cm$^{-3}$, a high-density ionized source material can be supplied to the plastic surface, and this makes it possible to speed up the film forming rate. However, because a self-bias voltage is not generated at the plastic container wall surfaces, the ionized material is not attracted to the plastic surface, and because ionic collisions do not occur, it is difficult to obtain a fine DLC film. Accordingly, the moisture and gas barrier properties are believed to be lower than those of the DLC film formed in the high-frequency capacitive coupling type discharge system. Further, the film thickness needs to be made large in order to secure the same moisture and gas barrier properties.

As the result of earnest research which should solve the specific problems of the two manufacturing methods described above, the present inventors effectively combined the high-frequency capacitive coupling type discharge system and the microwave discharge system, and discovered a film forming mechanism for forming a high-quality film with good productivity which is different than the film forming mechanism of each method, whereby the present invention was achieved. Namely, this film forming mechanism is a mechanism which forms a DLC film by forcibly attracting ions created by plasma generated by microwaves to the outer wall surface or the inner wall surface of a plastic container by the self-bias caused by the high-frequency waves.

It is a first object of the present invention to provide an apparatus for manufacturing a DLC film coated plastic container which makes it possible to form a DLC film uniformly on the outer wall surface of a plastic container, prevents the creation of minute cracks in the film without applying a severe thermal load on the plastic container which is the material receiving film formation, and makes it possible to form a fine DLC film at a high film forming rate.

In this regard, the DLC film of the present invention is a film called an i-carbon film or an amorphous carbon hydride film (a - C : H), and also includes a hard carbon film. Further, a DLC film is an amorphous-state carbon film, and includes SP$^3$ bonding and SP$^2$ bonding. Further, this film includes a DLC film containing the element silicon Si.

Instead of a viewpoint referring to a large density, the fine DLC film mentioned in the present invention means a DLC film having a small product of the solubility coefficient of vapor molecules of oxygen, hydrogen, carbon dioxide, nitrogen or organic molecules or the like to the inside of the film and the dispersion coefficient of the vapor molecules.

Further, the moisture and gas barrier properties mentioned in the present invention are properties determined by the product of the solubility coefficient of the vapor molecules to the inside of the film and the dispersion coefficient of the vapor molecules described above (the fineness), the amount of minute cracks in the film and the film thickness. From the viewpoint of the moisture and gas barrier properties, an ideal DLC film satisfies the conditions of being fine, having a small amount of film cracks and having a film thickness within a prescribed film thickness range. When the film is fine and has a small amount of cracks, the required film thickness can be made small. Further, in general if the film thickness is too small, the entire surface of the plastic can not be covered, and if the film thickness is too large, the internal stress of the film will become large, and it becomes impossible to follow the flexibility of the plastic. In the present invention, the film thickness of the DLC film is $30 \sim 2000$Å, and preferably $50 \sim 1000$Å.

It is a second object of the present invention to provide an apparatus for manufacturing a DLC film coated plastic container which has a high-frequency bias electrode structure in the manufacturing apparatus described above which makes it possible to coat a DLC film on the container outer wall surface even when there is the state where the plastic container which is the film forming object is equipped with partition plates to make it possible to independently house a plurality of contents.

It is a third object of the present invention to provide an apparatus for manufacturing a DLC film coated plastic container which makes it possible to form a DLC film uniformly on the inner wall surface of a plastic container, prevents the creation of minute cracks without applying a severe thermal load on the plastic container which is the material receiving film formation, and makes it possible to form a fine DLC film at a high film forming rate.

It is a fourth object of the present invention to provide a method of manufacturing a DLC film coated plastic container which makes it possible to form a fine DLC film uniformly on the container outer wall surface at a high film forming rate while preventing the creation of minute cracks without applying a severe thermal load on the plastic container which is the material receiving film formation, wherein source gas ions are attracted to the outer wall surface of the plastic container by supplying microwaves to the inside of a vacuum chamber to generate a source gas plasma inside the vacuum chamber, and simultaneously supplying a high-frequency output to a high-frequency bias electrode to generate a self-bias voltage at the outer wall surface of the plastic container.

It is a fifth object of the present invention to provide a method of manufacturing a DLC film coated plastic container which makes it possible to coat a DLC film on the container outer wall surface even when there is the state where the plastic container which is the film forming object is equipped with partition plates to make it possible to independently house a plurality of contents.

It is a sixth object of the present invention to provide a method of manufacturing a DLC film coated plastic container which makes it possible to form a fine DLC film uniformly on the container inner wall surface at a high film forming rate while preventing the creation of minute cracks without applying a severe thermal load on the plastic container which is the material receiving film formation, wherein source gas ions are attracted to the inner wall surface of the plastic container by supplying microwaves to the inside of the plastic container to generate a source gas plasma inside the plastic container, and simultaneously supplying a high-frequency output to a vacuum chamber to generate a self-bias voltage at the inner wall surface of the plastic container.

It is a seventh object of the present invention to provide a plastic container having moisture and gas barrier properties even when the container has a complex shape in which partition plates are provided to make it possible to independently house a plurality of contents.

The solution means for achieving each of the objects described above are as follows.

The apparatus for manufacturing a DLC film coated plastic container according to the present invention is an apparatus which forms a DLC film on the outer wall surface of said plastic container, and is equipped with a grounded vacuum chamber for housing said plastic container; a high-frequency bias electrode which is provided inside said vacuum chamber via an insulating body at a position in contact with the inner wall surface of said plastic container or near said inner wall surface; a microwave supply means which generates a source gas plasma inside said vacuum chamber by introducing microwaves inside said vacuum chamber; a high-frequency output supply means connected to said high-frequency bias electrode to generate a self-bias voltage at the outer wall surface of said plastic container; and a source gas supply means which introduces a source gas inside said vacuum chamber. Further, in this manufacturing apparatus, said high-frequency bias electrode is formed to have an electrode structure which is positioned in contact with the inner wall surfaces of a plastic container equipped with partition plates or near said inner wall surfaces.

Further, the apparatus for manufacturing a DLC film coated plastic container according to the present invention is an apparatus which forms a DLC film on the inner wall surface of said plastic container, and is equipped with an external electrode which also serves as a vacuum chamber for housing said plastic container positioned near the outer wall surface of said plastic container; an internal electrode which is inserted in the opening of said plastic container and is grounded in an insulated state with respect to said external electrode; a microwave supply means which generates a source gas plasma inside said plastic container by introducing microwaves inside said plastic container; a high-frequency output supply means connected to said external electrode to generate a self-bias voltage at the inner wall surface of said plastic container; and a source gas supply means which introduces a source gas inside said plastic container. The external electrode which also serves as a vacuum chamber has an internal shape for housing the plastic container and is positioned near the outer wall surface of the plastic container, the external shape of the plastic container and the internal shape of the external electrode have roughly similar shapes, and includes the case where the inner surface of the external electrode makes contact with the outer surface of the plastic container.

Further, the method of manufacturing a DLC film coated plastic container according to the present invention is a method of manufacturing a DLC film coated plastic container in which a DLC film is formed on the outer wall surface of said plastic container, and includes the steps of housing said plastic container in a grounded vacuum chamber, and setting a high-frequency bias electrode in an insulated state with respect to said vacuum chamber at a position in contact with the inner wall surface of said plastic container or near said inner wall surface; and then supplying a source gas inside said vacuum chamber; and forming a DLC film on the outer wall surface of said plastic container by supplying microwaves inside said vacuum chamber to generate a source gas plasma inside said vacuum chamber, and simultaneously supplying a high-frequency output to said high-frequency bias electrode to generate a self-bias voltage at the outer wall surface of said plastic container. In this manufacturing method, said plastic container is a plastic container equipped with partition plates, and said high-frequency bias electrode is formed to have an electrode structure which is positioned in contact with the inner wall surfaces of said plastic container equipped with said partition plates or near said inner wall surfaces.

Further, the method of manufacturing a DLC film coated plastic container according to the present invention is a method of manufacturing a DLC film coated plastic container in which a DLC film is formed on the inner wall surface of said plastic container, and includes the steps of housing said plastic container inside a vacuum chamber so that the outer wall surface of said plastic container is roughly in contact with the inner wall surface of said vacuum chamber, and inserting a grounded internal electrode in an insulated state with respect to said vacuum chamber from the opening of said plastic container; and then supplying a source gas inside said plastic container; and forming a DLC film on the inner wall surface of said plastic container by supplying microwaves inside said plastic container to generate a source gas plasma inside said plastic container, and simultaneously supplying a high-frequency output to said vacuum chamber to generate a self-bias voltage at the inner wall surface of said plastic container.

Further, in the DLC film coated plastic container according to the present invention, a DLC film having moisture and gas barrier properties is formed on the outer wall surface of a plastic container equipped with partition plates.

The outer wall surface of the plastic container in the present invention refers to the surface which makes contact with the outside air excluding the opening (hole portion), and the inner wall surface refers to the surface having an inside/outside relationship with respect to the outer wall surface. Accordingly, both front and back surfaces of the partition plates are not included in the inner wall surface.

Further, in the manufacturing apparatus described above, the high-frequency output supply means not only generates a self-bias but also obtains plasma generation, but the plasma generation of the high-frequency output supply means can not be anything more than just an auxiliary means of the microwave output supply means which is the plasma generating means. Even in the manufacturing method, the plasma generation due to the high-frequency output supply is an auxiliary generation.

Further, instead of being separated from the plasma, the inner wall surface or the outer wall surface of the plastic container is preferably in contact with the plasma generating space.

In the present invention, the self-bias voltage generated at the outer wall surface or the inner wall surface of the plastic container may be made positive or negative depending on the film forming pressure and the surface area ratio of the electrode and the facing electrode thereof, but a negative self-bias voltage is preferably applied to the outer wall surface or the inner wall surface.

**BRIEF DESCRIPTION OF THE DRAWINGS**

Fig. 1 is a conceptual view showing one embodiment of an apparatus for manufacturing a DLC film coated plastic container according to the present invention, and is the case where a DLC film is coated on the outer wall surface of the container.

Fig. 2 shows views of one embodiment of a plastic container equipped with partition plates which make it possible to independently house a plurality of contents, wherein (a) is a container equipped with three compartments, and (b) is a container equipped with six compartments.

Fig. 3 is a conceptual view showing one embodiment of an electrode structure of a high-frequency bias electrode, wherein (a) shows an electrode structure corresponding to the container of Fig. 2(a), and (b) shows an electrode structure corresponding to the container of Fig. 2(b).

Fig. 4 is a conceptual view showing one embodiment of an apparatus for manufacturing a plastic container in the case where a plurality of windows for supplying microwaves are provided when a DLC film is coated on the outer wall surface of the container, wherein (a) shows the case where a plurality of microwave supply means are provided, and (b) shows the case where one microwave supply means is provided.

Fig. 5 is a conceptual view showing one embodiment of an apparatus for manufacturing a DLC film coated plastic container according to the present invention, and is the case where a DLC film is coated on the inner wall surface of the container.

A description of the reference characters in the drawings is as follows. 1, 31 are plastic containers, 2, 32 are vacuum chambers, 3, 45 are insulating bodies, 4 is a high-frequency bias electrode, 5, 35 are mode converters, 7, 37 are waveguides, 8, 38 are isolators, 9, 39 are microwave generating units, 10, 34 are microwave supply means, 6, 36, 11, 52 are impedance matchers (matching units), 12, 51 are high-frequency power supplies, 13, 53 are high-frequency output supply means, 14, 16, 21, 40, 42, 47 are vacuum valves, 15, 41 are mass flow controllers, 17, 50 are source gas supplies, 18, 43 are source gas supply means, 19,44 are windows (quartz windows), 20, 46 are pipes, 22, 48 are vacuum pumps, 32 is an external electrode, 33 is an internal electrode, 49 is a shield box, and 100, 200 are apparatuses for manufacturing a DLC film coated plastic container.

**PREFERRED EMBODIMENTS OF THE INVENTION**

A detailed description of the preferred embodiments of the present invention is given below, but the present invention should not be interpreted as being limited to these preferred embodiments and specific embodiments.

First Embodiment: Case where DLC Film is Coated on Outer Wall Surface of Plastic Container

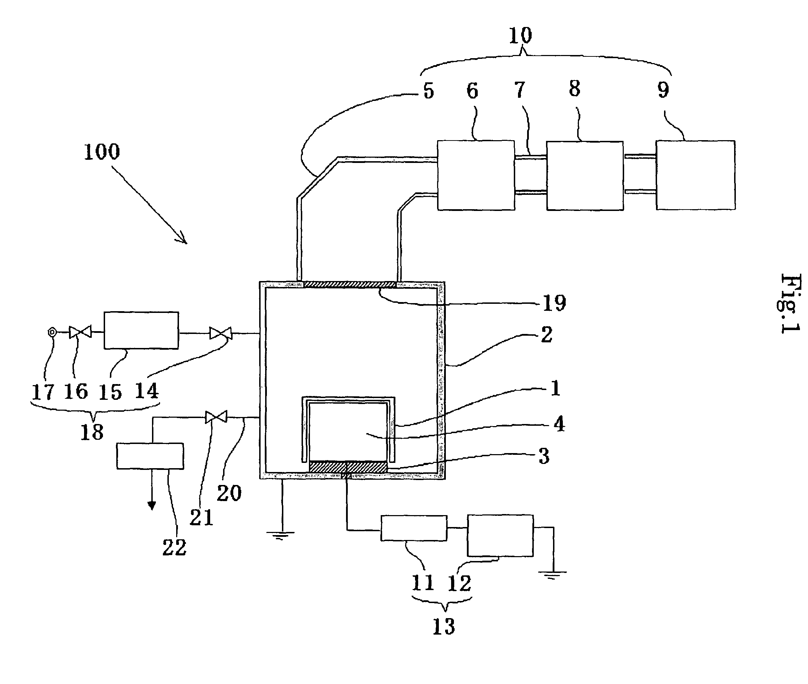

The first embodiment will be described with reference to Fig. 1.

An apparatus 100 for manufacturing a DLC film coated plastic container according to the present invention is equipped with a grounded vacuum chamber 2 for housing a plastic container 1, a high-frequency bias electrode 4 provided via an insulating body 3 inside the vacuum chamber 4 positioned in contact with the inner wall surface or near such inner wall surface of the plastic container 1, microwave supply means 10 which generates a source gas plasma inside the vacuum chamber 2 by introducing microwaves inside the vacuum chamber 2, high-frequency output supply means 13 which is connected to the high-frequency bias electrode 4 to generate a bias voltage at the outer wall surface of the plastic container 1 by supplying a high-frequency output, and a source gas supply means 18 which introduces a source gas inside the vacuum chamber 2.

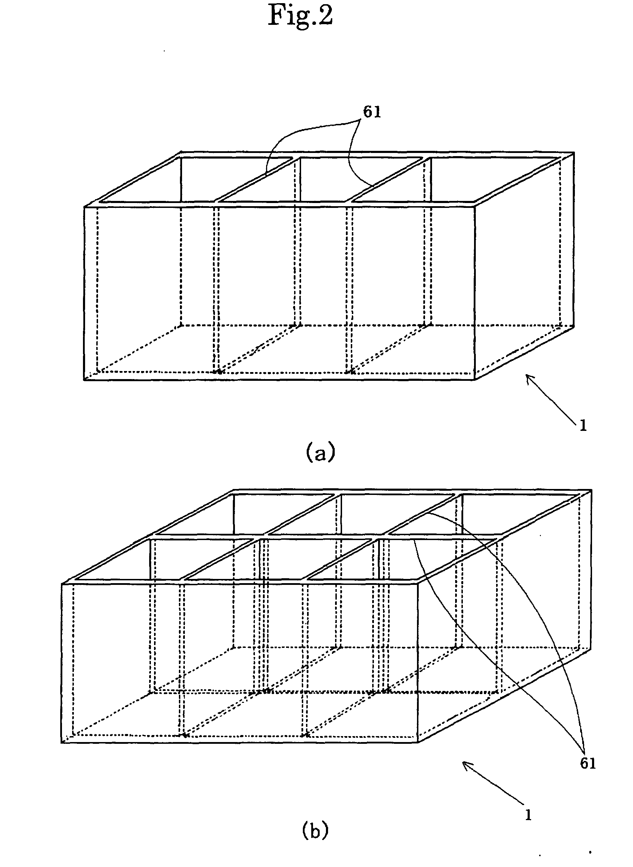

The shape of the plastic container 1 includes shapes in which an opening (hole portion) becomes narrow with respect to a body portion as in bottle shapes for beverages, and shapes in which the opening has the same or a slightly larger diameter with respect to the body portion as in tub shapes or beaker shapes. This includes containers having a stopper or a cover. Further, a plastic container equipped with partition plates like that shown in Fig. 2 is included in the present invention. By being equipped with partition plates, it becomes possible to independently house a plurality of contents. By coating the outer wall surface of a plastic container equipped with partition plates with a DLC film having moisture and gas barrier properties, it is possible to inhibit the contamination of atmospheric gases and water vapor gas to the contents, or the volatilization of gas components from the contents. Further, because the DLC film is not coated on the partition plates, there is no DLC film function that prevents the transfer of gas components between each of the contents.

As for the material of the plastic container, polyethylene terephthalate resin (PET), polyethylene terephthalate type copolyester resin (a copolymer called PETG which uses cyclohexane demethanol in place of ethylene glycol in the alcohol component of polyester, produced by Eastman Chemical Company), polybutylene terephthalate resin, polyethylene naphthalate resin, polyethylene resin, polypropylene resin (PP), cycloolefin copolymer resin (COC, ring olefin copolymer), ionomer resin, poly-4-methylpentene-1 resin, polymethyl methacrylate resin, polystyrene resin, ethylene-vinyl alcohol copolymer resin, acrylonitrile resin, polyvinyl chloride resin, polyvinylidene chloride resin, polyamide resin, polyamide imide resin, polyacetal resin, polycarbonate resin, polysulfone resin, or ethylene tetrafluoride resin, acrylonitrile-styrene resin, acrylonitrile-butadiene-styrene resin are good, but PET, PETG, PP or COC is preferred because superior properties are exhibited. In the present embodiment, a container made of PET, PETG, COC or PP is used.

The vacuum chamber 2 has a size which houses at least the plastic container 1. The vacuum chamber 2 is not a simple vacuum chamber, and forms an electrode which forms a pair with the high-frequency bias electrode 4. Because the electrode is grounded, there is 0V potential. Further, in order to introduce microwaves inside the vacuum chamber 2 from the microwave supply means 10, and in order to decrease the pressure of the chamber at the time microwaves are introduced, a window 19 is provided at the connection portion of the microwave supply means 10 and the vacuum chamber 2. Further, in the present invention, the position of the window is not limited to the place shown in Fig. 1. The material of the window 19 is preferably quartz glass. Further, the vacuum chamber 2 is equipped with an open/close mechanism (not shown in the drawings) which makes it possible to take out or put in the plastic container 1.

The insulating body 3 insulates the grounded vacuum chamber 2 and the high-frequency bias electrode 4. Any shape and material may be used so long as this function is achieved. For example, a sintered plate of alumina represents an example.

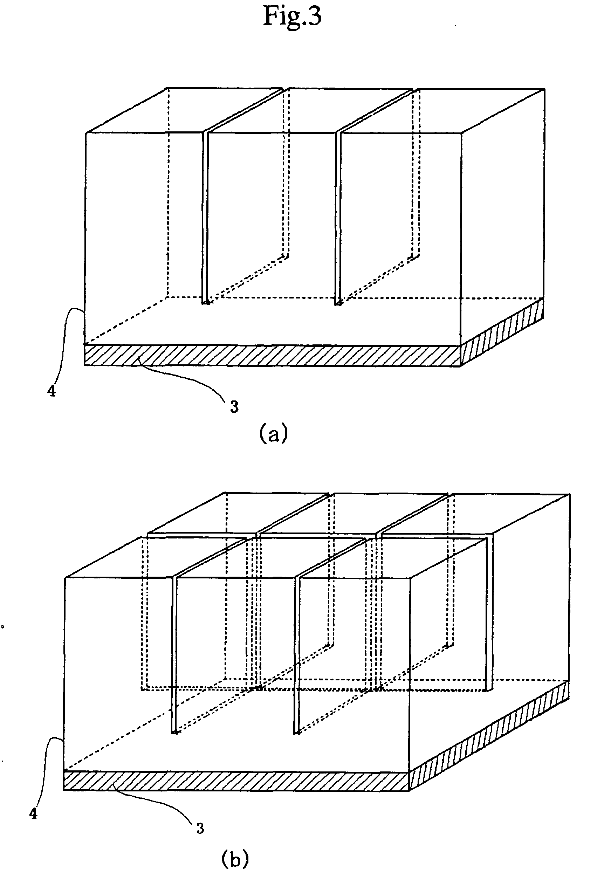

The high-frequency bias electrode 4 is shaped so as to make contact with the inner wall surface of the plastic container 1 or be positioned near such inner wall surface. Preferably, there is contact over the entire inner wall surface of the plastic container 1, but there may be separation so long as the inner wall surface and the outer surface of the high-frequency bias electrode 4 are not separated locally. Namely, the inner shape of the plastic container 1 and the outer shape of the high-frequency bias electrode 4 have similar shapes. Further, in the case where the plastic container 1 has a shape like the example shown in Fig. 2(a), the high-frequency bias electrode 4 preferably has the electrode structure shown in Fig. 3(a). The high-frequency bias electrode corresponding to Fig. 2(b) has the electrode structure shown in Fig. 3(b). This is because the presence of the partition walls of the container forms obstructions which make it impossible for the container inner wall surfaces to make contact with the high-frequency bias electrode 4. Further, the high-frequency bias electrode 4 is in a state insulated from the grounded vacuum chamber 2.

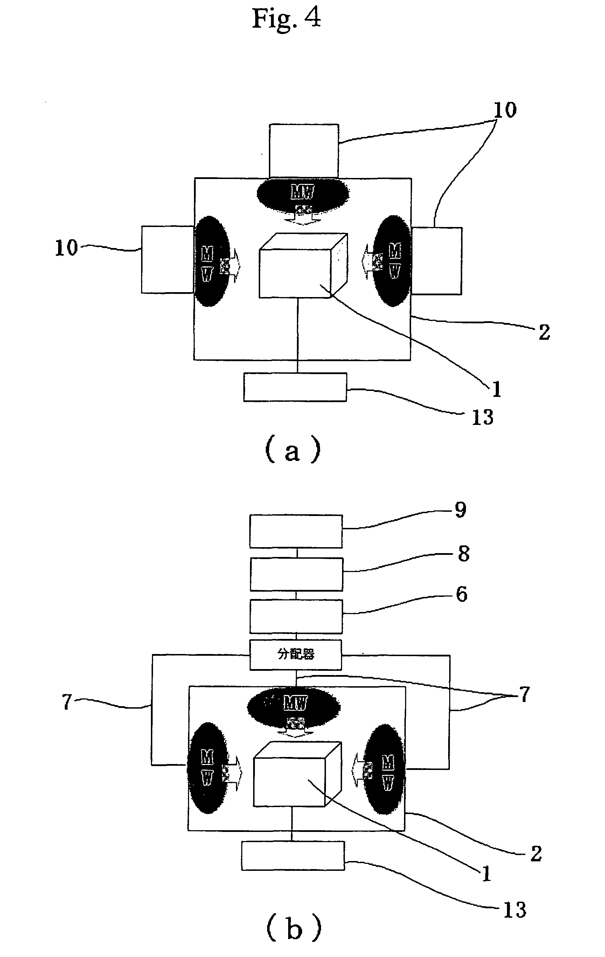

The microwave supply means 10 generates a source gas plasma inside the vacuum chamber 2 by introducing microwaves inside the vacuum chamber 2. As shown in Fig. 1, the microwave supply means 10 is constructed from a microwave generating unit 9 which generates microwaves (e.g., 2.45GHz), an isolator 8, an impedance matcher 6 and a mode converter 5. Each of the microwave generating unit 9, the isolator 8 and the impedance matcher 6 is connected via a waveguide 7 which passes microwaves. The structure of the microwave supply means 10 is not limited to the structure shown in Fig. 1, and any structure may be used so long as it is possible to introduce microwaves inside the vacuum chamber 2 with good efficiency. As shown in Fig. 4, a plurality of windows for supplying microwaves may be provided. In Fig. 4, (a) shows the case where a plurality of microwave supply means are provided, and (b) shows the case where one microwave supply means is provided, and one of these is selected depending on the size of the container. In the case where the plastic container has a large size, the apparatus shown in Fig. 4 is preferably used. Further, Fig. 4 does not show the waveguide, the mode converter, the isolator, the impedance matcher and the like.

The high-frequency output supply means 13 is constructed from a high-frequency power supply 12 and an impedance matcher 11 as shown in Fig. 1. The impedance matcher 11 is insulated from the vacuum chamber, and connected to the high-frequency bias electrode 4. Further, the impedance matcher 11 is connected to a high-frequency power supply (RF power supply, 13.56MHz) 12 via a coaxial cable. Further, the high-frequency power supply 12 is grounded.

The source gas supply means 18 introduces a source gas to the inside of the vacuum chamber 2. One side of a vacuum valve 16 is connected to the output side of a source gas supply 17, a flow meter (mass flow controller) 15 for adjusting the source gas flow rate is connected to the other side of the vacuum valve 16, one side of a vacuum valve 14 is connected to the other side of the flow meter 15, and the vacuum chamber 2 is connected to the other side of the vacuum valve 14. The source gas supply means may be given a structure different than that described above so long as it is possible to supply a source gas at a prescribed flow rate inside the vacuum chamber 2. There is no limitation to the place where the source gas supply means 18 is connected to the vacuum chamber 2, but a position where the source gas does not settle in a specific place is preferred.

Aliphatic hydrocarbons, aromatic hydrocarbons, hydrocarbons containing oxygen, hydrocarbons containing nitrogen and the like which are a gas or a liquid at normal temperature are used as the source gas. In particular, benzene, toluene, 0-xylene, m-xylene, p-xylene, cyclohexane and the like which have a carbon number of 6 or higher are preferred. In the case of use in a container of food and the like, from the viewpoint of hygiene, aliphatic hydrocarbons, namely, ethylene hydrocarbons such as ethylene, propylene or butylene or the like, or acetylene hydrocarbons such as acetylene, allyrene or 1-butyne or the like. These source materials may be used individually, or a mixed gas of two or more kinds may be used. Further, these gases may be used in a form where they are diluted by a noble gas such as argon or helium.

Further, in the case where a DLC film containing silicon is formed, a hydrocarbon gas containing Si is used.

The space inside the vacuum chamber 2 is connected to one side of a pipe 20, and the other side of the pipe 20 is connected to a vacuum pump 22 via a vacuum valve 21. The vacuum pump 22 is connected to the exhaust side.

The present invention is not limited to the embodiment described above, and various changes can be made thereto. For example, in the present embodiment, a description was given in accordance with an apparatus for one plastic container, but it is possible to construct a film forming apparatus which makes it possible to simultaneously coat a plurality of plastic containers by providing a plurality of high-frequency bias electrodes inside the vacuum chamber 2.

In the present embodiment, the container having a thin film formed on the outer wall surface is primarily used as a food container such as a lunch box or the like, or a beverage container, and an ink cartridge for a recording printer which has an ink jet recording system or the like can form another example, but there is no limit to the applications.

In the present embodiment, a DLC film or a DLC film container Si is used as the thin film formed by the CVD film forming apparatus, but the film forming apparatus described above can also be used when forming other thin films inside the container.

Next, a description will be given for the method of forming a DLC film on the outer wall surface of a container using the apparatus 100 for manufacturing a DLC film coated plastic container shown in Fig. 1.

First, a vacuum valve (not shown in the drawings) is opened to open the inside of the vacuum chamber 2 to the atmosphere. In this way, air flows in, and the inside of the vacuum chamber 2 reaches atmospheric pressure. Next, the vacuum chamber is opened by an open/close mechanism (not shown in the drawings) of the vacuum chamber 2, and a plastic container 1 is provided by being fitted onto the high-frequency bias electrode 4 from the opening thereof. At this time, the outer surface of the high-frequency bias electrode 4 and the inner wall surface of the plastic container 1 form a rough contacting state. Next, the vacuum chamber is closed and sealed by the open/close mechanism (not shown in the drawings) of the vacuum chamber 2.

Then, after the vacuum valve (not shown in the drawings) is closed, the vacuum valve 21 is opened, and air is exhausted by the vacuum pump 22. In this way, the inside of the vacuum chamber 2 is exhausted through the pipe 20 to lower the pressure inside the vacuum chamber 2. At this time, the pressure inside the vacuum chamber 2 is $5 \times 10^{-3} \sim 5 \times 10^{-2}$ Torr.

Next, the vacuum valve 16 is opened, a hydrocarbon gas is generated in the source gas supply 17, this hydrocarbon gas is introduced into a pipe, and then the hydrocarbon gas having a controlled flow rate by the flow meter 15 is blown out inside the vacuum chamber 2 via the vacuum valve 14. In this way, a hydrocarbon gas is introduced inside the vacuum chamber 2. Then, by balancing the controlled gas flow rate and the exhaust capacity, a pressure (e.g., about $0.05 \sim 0.50$ Torr) suited to DLC film formation is maintained inside the vacuum chamber 2.

Then, microwaves (e.g., 2.45GHz) at $50 \sim 1000$W are supplied to the vacuum chamber 2 by the microwave supply means 10. This output value is an example, and adjustments are carried out in accordance with the size of the vacuum chamber and the container. The impedance is adjusted so that the output is supplied inside the chamber with good efficiency. A source gas plasma is generated inside the vacuum chamber 2 by the supplied microwaves. The density of the plasma can be made $10^{11} \sim 10^{12}$ cm$^{-3}$.

At the same time or roughly the same time as the microwave supplying described above, a high-frequency output (e.g., 13.56MHz) at $10 \sim 1000$W is supplied to the high-frequency bias electrode 4 from the high-frequency power supply 12 via the impedance matcher 11. At this time, the impedance matcher 11 matches the impedance of the high-frequency bias electrode 4 and vacuum chamber 2 by the inductance L and the capacitance C. A self-bias voltage is generated at the outer wall surface of the plastic container 1 by the supplied high-frequency waves. Positively charged ions from the source gas plasma generated by the microwaves are attracted to the high-frequency bias electrode 4. In this way, the positively charged ions collide with the outer wall surface of the plastic container 1 and form a DLC film. The film formation time at this time is around several seconds which is short. The high-frequency output value described above is an example, and adjustments are carried out in accordance with the size and the like of the vacuum chamber and the container, and in particular the value is changed for the purpose of adjusting the self-bias. This adjustment is for forming a DLC film having a prescribed fineness in accordance with the container.

In the present invention as described above, the microwave supply rate and the high-frequency output are controlled independently. In general, a plasma is also generated by the high-frequency output. However, the plasma density at such time is up to $10^9$ cm$^{-3}$ which is a low density. Namely, in the present invention, the contribution of plasma generation due to high-frequency output is believed to be about 1/100 $\sim$ 1/1000 of the contribution of plasma generation due to microwaves. Accordingly, in the present invention, there is a mechanism for forming a DLC film in which the ions created by the plasma generated by microwaves are forcibly attracted to the outer wall surface of the plastic container by the self-bias caused by the high-frequency output. This is different from the single system of the high-frequency capacitive coupling type discharge system or the microwave discharge system of the prior art. Further, as described later in specific examples, the DLC film obtained by the present invention is a higher quality film than that made by the single systems described above from the viewpoint of water and gas barrier properties, and film formation can be carried out with good productivity.

Next, the high-frequency output from the high-frequency power supply 12 is stopped, and at the same time the microwave output from the microwave generating unit 9 is also stopped. The vacuum valves 16, 14 are closed and the supply of the source gas is stopped. Then, the vacuum valve 21 is opened, and the hydrocarbon gas inside the vacuum chamber 2 is exhausted by the vacuum pump 22. Then, the vacuum valve 21 is closed, and the vacuum pump 22 is stopped. In the case where a film is to be formed on the next plastic container, the vacuum pump 22 is kept in an operating state without being stopped. The pressure inside the vacuum chamber 2 at this time is $5 \times 10^{-3} \sim 5 \times 10^{-2}$ Torr. Then, a vacuum valve (not shown in the drawings) is opened to open the inside of the vacuum chamber 2 to the atmosphere, and by repeatedly carrying out the manufacturing method described above, a DLC film is formed on the outer wall surface of the next plastic container.

Further, in the present embodiment, a description was given using a plastic container which does not have partition plates, but a plastic container equipped with partition plates which make it possible to independently house a plurality of contents as shown in Figs. 2(a)(b) may be used. In this case, a high-frequency bias electrode having the electrode structure shown in Figs. 3(a)(b), for example, may be used.

Second Embodiment: Case where DLC Film is Coated on Inner Wall Surface of Plastic Container

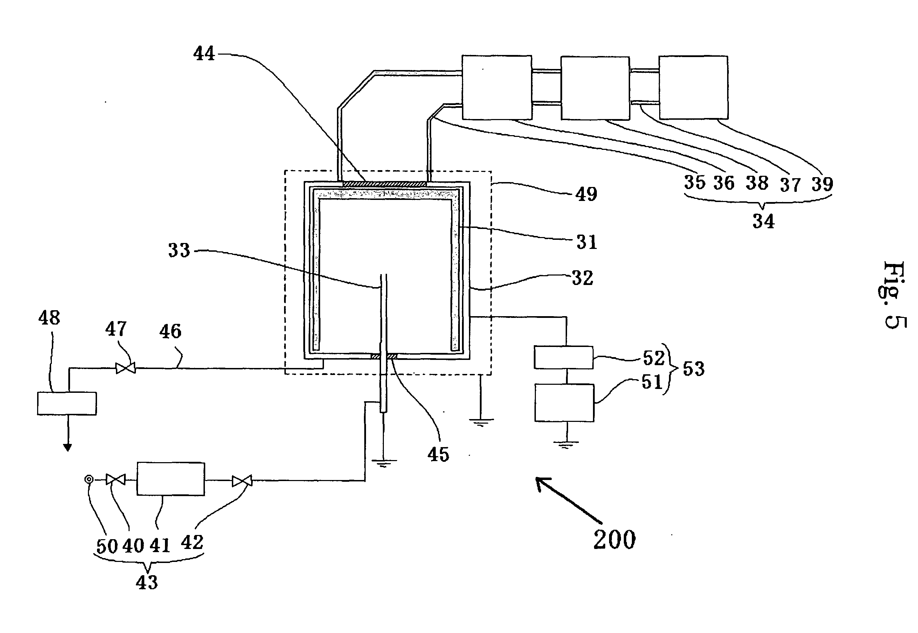

An embodiment will be described with reference to Fig. 5. An apparatus 200 for manufacturing a DLC film coated plastic container according to the present invention is equipped with an external electrode 32 which also serves as a vacuum chamber for housing a plastic container 31 positioned near the outer wall surface of the plastic container 31, an internal electrode 33 which also serves as a gas introduction pipe that is inserted in the opening of the plastic container 31 and is grounded in an insulated state with respect to the external electrode 32, a microwave supply means 34 which generates a source gas plasma inside the plastic container 31 by introducing microwaves inside the external electrode 32, a high-frequency output supply means 53 connected to the external electrode 32 to generate a self-bias voltage at the inner wall surface of the plastic container 31, and a source gas supply means 43 which introduces a source gas inside the plastic container 31.

The plastic container 31 has the same shape and material as that described in the first embodiment.

The external electrode 32 houses the plastic container 31 and is positioned near the outer wall surface of the plastic container 31. Namely, the external shape of the plastic container 31 and the internal shape of the external electrode 32 have similar shapes. Preferably, there is contact over the entire outer wall surface of the plastic container 31, but there may be separation so long as the outer wall surface and the inner surface of the external electrode 32 are not separated locally. Further, because the external electrode 32 also serves as a vacuum chamber, it has a sealing capability.

The external electrode 32 is a vacuum chamber and forms an electrode which forms a pair with the internal electrode 33. Further, in order to introduce microwaves inside the external electrode 32 from the microwave supply means 34, and in order to decrease the pressure of the chamber at the time microwaves are introduced, a window 44 is provided at the connection portion of the microwave supply means 34 and the external electrode 32. The material of the window 44 is preferably quartz glass. Further, the external electrode 32 is equipped with an open/close mechanism (not shown in the drawings) which makes it possible to take out or put in the plastic container 31.

The internal electrode 33 is inserted in the opening of the plastic container 31 and is grounded in an insulated state with respect to the external electrode 32. The internal electrode structure has a pipe shape, for example, and also serves as a gas introduction pipe. A source gas is blown out from the end portion at the side inserted in the opening of the internal electrode 33. The length of the internal electrode 33 is appropriately adjusted so that a DLC film is formed on the inner wall surface of the plastic container 31 uniformly from the viewpoint of moisture and gas barrier properties.

An insulating body 45 insulates the internal electrode 33 and the external electrode 32. Any shape and material may be used so long as this function is achieved.

The microwave supply means 34 is the same as that described in the first embodiment.

The high-frequency output supply 53 is different from the first embodiment with regards to the point of being connected to the external electrode 32 to supply a high-frequency output to the external electrode, and the point of being provided to generate a self-bias voltage at the inner wall surface of the plastic container 31, but the arrangements of an impedance matcher 52 and a high-frequency power supply 51 are the same as those described in the first embodiment.

The source gas supply means 43 is connected to the other end of the one end (supply hole) of the internal electrode 33 inserted in the plastic container 31. The internal electrode has a pipe shape, and a source gas supply hole (not shown in the drawings) is provided at the tip thereof, wherein a source gas is blown out from the source gas supply hole. The structure in the source gas supply means 43 is the same as the structure described in the first embodiment.

The source gas is the same as that described in the first embodiment.

The space inside the external electrode 32 is connected to one side of a pipe 46, and the other side of the pipe 46 is connected to a vacuum pump 48 via a vacuum valve 47. The vacuum pump 48 is connected to the exhaust side.

In the second embodiment, the entire external electrode 32 is covered by a shield box 49. This prevents high-frequency waves from leaking to the outside.

The present invention is not limited to the embodiment described above, and various changes can be made thereto. For example, in the present embodiment, a description was given in accordance with an apparatus for one plastic container, but it is possible to construct a film forming apparatus which makes it possible to simultaneously coat a plurality of plastic containers by providing a plurality of these units.

In the present embodiment, the container having a thin film formed on the inner wall surface can be used as a food container or a beverage container, but there is no limit to the applications.

In the present embodiment, a DLC film or a DLC film containing Si is used as the thin film formed by the CVD film forming apparatus, but the film forming apparatus described above can also be used when forming other thin films inside the container, and this point is the same as that described in the first embodiment.

In the first embodiment, the vacuum chamber functions as a counter electrode of the high-frequency bias electrode, and in the second embodiment, the internal electrode functions as a counter electrode of the external electrode which also serves as a vacuum chamber, but these counter electrodes are examples, and grounded counter electrodes and the like may be used separately. The present invention is not limited by the places where the counter electrodes are arranged.

Next, a description will be given for the method of forming a DLC film on the inner wall surface of a container using the apparatus 200 for manufacturing a DLC film coated plastic container shown in Fig. 5.

First, a vacuum valve (not shown in the drawings) is opened to open the inside of the external electrode 32 to the atmosphere. In this way, air flows in, and the inside of the external electrode 32 reaches atmospheric pressure. Next, the external electrode is opened by an open/close mechanism (not shown in the drawings) of the external electrode 32, and a plastic container 31 is provided by being housed inside the external electrode in a direction where the bottom portion thereof makes contact with the quartz window 44. At this time, the inner surface of the external electrode 32 and the outer wall surface of the plastic container 31 form a rough contacting state. Next, the external electrode is closed and sealed by the open/close mechanism (not shown in the drawings) of the external electrode 32. The internal electrode 33 is in an inserted state through the opening of the plastic container 31.

Then, after the vacuum valve (not shown in the drawings) is closed, the vacuum valve 47 is opened, and air is exhausted by the vacuum pump 48. In this way, the inside of the plastic container 31 is exhausted through the pipe 46 to lower the pressure inside the plastic container 31. At this time, the pressure inside the plastic container 31 is $5 \times 10^{-3} \sim 5 \times 10^{-2}$ Torr.

Next, the vacuum valve 40 is opened, a hydrocarbon gas is generated in a source gas supply 50, this hydrocarbon gas is introduced into a pipe, and then the hydrocarbon gas having a controlled flow rate by a flow meter 41 is blown out inside the plastic container 31 via a vacuum valve 42 from the supply hole (the opening of the tip portion of the internal electrode 33) of the internal electrode 33. In this way, a hydrocarbon gas is introduced inside the plastic container 31. Then, by balancing the controlled gas flow rate and the exhaust capacity, a pressure (e.g., about $0.05 \sim 0.50$ Torr) suited to DLC film formation is maintained inside the plastic container 31.

Then, microwaves (e.g., 2.45GHz) at 50 ~ 1000W are supplied to the inside of the plastic container 31 by the microwave supply means 34. This output value is an example, and adjustments are carried out in accordance with the size of the external electrode and the container. The impedance is adjusted so that the output is supplied inside the chamber with good efficiency. A source gas plasma is generated inside the plastic container 31 by the supplied microwaves. The density of the plasma can be made $10^{11} \sim 10^{12}$ cm$^{-3}$.

At the same time or roughly the same time as the microwave supplying described above, a high-frequency output (e.g., 13.56MHz) at 10 ~ 1000W is supplied to the external electrode 32 from the high-frequency power supply 51 via the impedance matcher 52. At this time, the impedance matcher 52 matches the impedance of the internal electrode 33 and the external electrode 32 by the impedance L and the capacitance C. A self-bias voltage is generated at the inner wall surface of the plastic container 31 by the supplied high-frequency waves. Positively charged ions from the source gas plasma generated by the microwaves are attracted to the external electrode 32. In this way, the positively charged ions collide with the inner wall surface of the plastic container 31 and form a DLC film. The film formation time at this time is around several seconds which is short. The high-frequency output value described above is an example, and adjustments are carried out in accordance with the size and the like of the vacuum chamber and the container, and in particular the value is changed for the purpose of adjusting the self-bias. This adjustment is for forming a DLC film having a prescribed fineness in accordance with the container.

In the second embodiment, the microwave supply rate and the high-frequency output are controlled independently in the same way as in the first embodiment. In the second embodiment, there is a mechanism for forming a DLC film in which the ions created by the plasma generated by microwaves are forcibly attracted to the inner wall surface of the plastic container by the self-bias caused by the high-frequency output, and this is different from the single system of the high-frequency capacitive coupling type discharge system or the microwave discharge system of the prior art. Further, the DLC film obtained by the present invention is a higher quality film than that made by the single systems described above from the viewpoint of water and gas barrier properties, and film formation can be carried out with good productivity.

Next, the high-frequency output from the high-frequency power supply 51 is stopped, and at the same time the microwave output from the microwave generating unit 39 is also stopped. The vacuum valves 40, 42 are closed and the supply of the source gas is stopped. Then, the vacuum valve 47 is opened, and the hydrocarbon gas inside the plastic container 31 is exhausted by the vacuum pump 48. Then, the vacuum valve 47 is closed, and the vacuum pump 48 is stopped. In the case where a film is to be formed on the next plastic container, the vacuum pump 48 is kept in an operating state without being stopped. The pressure inside the external electrode 32 at this time is $5 \times 10^{-3} \sim 5 \times 10^{-2}$ Torr. Then, a vacuum valve (not shown in the drawings) is opened to open the inside of the external electrode 32 to the atmosphere, and by repeatedly carrying out the manufacturing method described above, a DLC film is formed on the inner wall surface of the next plastic container.

SPECIFIC EMBODIMENTS

Forming a DLC Film on the Outer Wall Surface of a Plastic Container

Specific Embodiment 1

A DLC film was formed on the outer wall surface of a plastic container using the manufacturing apparatus of Fig. 1 described in the first embodiment, and then evaluations were carried out.

The plastic container used a container (Fig. 2(a), capacity 2000ml, 10cm $\times$ 20cm $\times$ 10cmH, resin thickness 2mm, surface area 800cm$^2$) equipped with partition plates. At this time, a high-frequency bias electrode having the electrode structure shown in Fig. 3(a) is used. However, the same results are obtained even with a container not equipped with partition plates.

The container material was PETG. The source gas used acetylene.

The film forming pressure inside the vacuum chamber was 0.10Torr, the source gas flow rate was 250sccm, the film formation time was 2 seconds, the high-frequency output was 500W, and the microwave output was 500W. The plasma CVD conditions are shown in Table 1.

Specific Embodiment 2

Except for the high-frequency output being 350W, and the microwave output being 600W, Specific Embodiment 2 was made the same way as Specific Embodiment 1.

Specific Embodiment 3

Except for the high-frequency output being 600W, and the microwave output being 250W, Specific Embodiment 3 was made the same way as Specific Embodiment 1. Further, Specific Embodiment 3 is an example in which the high-frequency output is the main output and the microwave output is an auxiliary output in the generation of plasma, and in order to compensate for the defect in the high-frequency capacitive coupling type discharge system which has a small plasma density, there are conditions in which microwaves are introduced supplementarily to raise the plasma density.

Specific Embodiment 4

Except for the container material being COC, Specific Embodiment 4 was made the same way as Specific Embodiment 1.

Specific Embodiment 5

Except for the container material being PP, Specific Embodiment 5 was made the same way as Specific Embodiment 1.

Comparative Example 1

Except for the high-frequency output being 0W, and the microwave output being 800W, Comparative Example 1 was made the same way as Specific Embodiment 1.

Comparative Example 2

Except for the microwave output being 0W, the high-frequency output being 800W, the source gas flow rate being 80sccm, and the film formation time being 6 seconds, Comparative Example 2 was made the same way as Specific Embodiment 1.

Comparative Example 3

Comparative Example 3 was made a control by not forming a film on a container made of PETG.

Comparative Example 4

Comparative Example 4 was made a control by not forming a film on a container made of COC.

Comparative Example 5

Comparative Example 5 was made a control by not forming a film on a container made of PP.

TABLE 1

| | Film Forming Pressure Inside Vacuum Chamber (Torr) | Source Gas Flow Rate (sccm) | Container Material | Film Formation Time(s) | High-Frequency Output(W) | Microwave Output(W) |
|---|---|---|---|---|---|---|
| Specific Embodiment 1 | 0.10 | 250 | PETG | 2 | 500 | 500 |
| Specific Embodiment 2 | 0.10 | 250 | PETG | 2 | 350 | 600 |

TABLE 1   (continued)

| | Film Forming Pressure Inside Vacuum Chamber (Torr) | Source Gas Flow Rate (sccm) | Container Material | Film Formation Time(s) | High-Frequency Output(W) | Microwave Output(W) |
|---|---|---|---|---|---|---|
| Specific Embodiment 3 | 0.10 | 250 | PETG | 2 | 600 | 250 |
| Specific Embodiment 4 | 0.10 | 250 | COC | 2 | 500 | 500 |
| Specific Embodiment 5 | 0.10 | 250 | PP | 2 | 500 | 500 |
| Comparative Example 1 | 0.10 | 250 | PETG | 2 | 0 | 800 |
| Comparative Example 2 | 0.10 | 80 | PETG | 6 | 800 | 0 |
| Comparative Example 3 | - | - | PETG | - | - | - |
| Comparative Example 4 | - | - | COC | - | - | - |
| Comparative Example 5 | - | - | PP | - | - | - |

The following evaluations were carried out for the containers of Specific Embodiments 1 ~ 5 and Comparative Examples 1 ~ 5.

(1) Distribution of DLC Film

The thickness of the DLC film was measured by Tenchol Company's alpha-step500 tracer type difference meter. The film thickness was measured at each of three points of the opening lower portion, the body portion and the bottom portion of the container, and an average value was calculated. The film thickness distribution is defined by Equation 1 described below. The largest film thickness or the smallest film thickness is a corresponding film thickness from the average film thickness at the opening lower portion, the body portion and the bottom portion of the container.

Equation 1

Film Thickness Distribution [%] = (largest film thickness - smallest film

thickness) / (smallest film thickness + largest film thickness) $\times$ 100

Overall evaluations were carried out for the distribution of the DLC film, wherein ○ represents the case where the film thickness distribution is in the range 0 ~ 4%, Δ represents the case where the film thickness distribution is in the range 4 ~ 8%, and × represents the case where the film thickness distribution is greater than 8%.

(2) Presence/Absence of Deformation of Container

The case where the container is visually observed to have a deformation is represented by ×, and the case where there is no deformation is represented by ○.

(3) Film Formation Rate

The average film formation rate was calculated by dividing the average film thickness of the film thickness at the opening lower portion, the body portion and the bottom portion of the container by the film formation time.

(4) Oxygen Permeability

Measurements were made using an Oxtran manufactured by Modem Control Company under the conditions 22°C × 60% RH. The oxygen permeability (oxygen permeating through the outer wall surface) at the inside and outside was measured for the entire container.

(5) Moisture Permeability

The moisture permeability (moisture permeating through the inner wall surface) at the inside and outside was measured for the entire container. As for the moisture permeability of the container, calcium chloride was filled into each compartment of the container, the cover was sealed by a stainless steel plate, and then this was kept under the conditions 40°C × 90% RH. With the passing of time, the calcium chloride absorbs moisture and changes weight. The moisture permeability was evaluated by measuring this change in weight.
The evaluation results are shown in Table 2.

TABLE 2

| | Film Thickness (Å) | | | Film Thickness Distribution | Container Deformation | Film Formation Rate (Å/s) | Oxygen Permeability (ml/container/day) | Moisture Permeability (mg/container/100 days) |
|---|---|---|---|---|---|---|---|---|
| | Opening Lower Portion | Body Portion | Bottom Portion | | | | | |
| Specific Embodiment 1 | 600 | 600 | 620 | ○ | ○ | 304 | 0.010 | 690 |
| Specific Embodiment 2 | 630 | 620 | 610 | ○ | ○ | 310 | 0.009 | 610 |
| Specific Embodiment 3 | 550 | 560 | 570 | ○ | ○ | 280 | 0.017 | 750 |
| Specific Embodiment 4 | 600 | 600 | 620 | ○ | ○ | 304 | 0.035 | 110 |
| Specific Embodiment 5 | 590 | 580 | 600 | ○ | ○ | 295 | 0.210 | 380 |
| Comparative Example 1 | 620 | 550 | 520 | × | Δ | 315 | 0.051 | 2520 |
| Comparative Example 2 | 330 | 340 | 350 | ○ | ○ | 48 | 0.045 | 1840 |
| Comparative Example 3 | - | - | - | - | - | - | 0.122 | 3800 |
| Comparative Example 4 | - | - | - | - | - | - | 0.202 | 420 |
| Comparative Example 5 | - | - | - | - | - | - | 0.683 | 1100 |

In Specific Embodiments 1 ∼ 5, because a self-bias voltage is generated at the container outer wall surface, the film thickness distribution is excellent compared with Comparative Example 1 in which a self-bias is not applied.

In Specific Embodiment 1, with both the effect of introducing microwaves and the effect of introducing high-frequency waves, a fine film having high moisture and gas barrier properties was obtained, and it is believed that there were few cracks. However, the high-frequency output is large, and because an etching effect appears, the film formation rate is not the fastest in the specific embodiments.

In Specific Embodiment 2, a high-density plasma is formed by microwaves, and because a self-bias voltage is moderately generated due to the introduction of high-frequency waves, a fine film having the most superior moisture and gas barrier properties was obtained, and it is believed that there were very few cracks. Further, because the etching effect is not as strong as that of Specific Embodiment 1, the film formation rate is high.

In Specific Embodiment 3, the system is designed to create a high-density plasma by applying microwaves supplementarily under conditions in which a plasma is generated by high-frequency waves and ionic collisions occur due to self-bias. Although not as good as that of Specific Embodiment 1, a high fineness film having superior moisture and gas barrier properties was obtained, and it is believed that there were few cracks.

In Specific Examples 4 and 5, the material of the container was changed, but this had no specific effect, and the same tendencies as those of Specific Embodiment 1 were observed.

Comparative Example 1 is the case where only microwaves are introduced, and at this film thickness, sufficient moisture and gas barrier properties, in particular moisture gas barrier properties were not obtained. The ionized source material is not attracted to the plastic surface, and because ionic collisions are not created, the film is believed to lack fineness. Further, the film formation rate is fast, but the film thickness which makes it possible to secure moisture and gas barrier properties at a prescribed level is believed to be large compared to the other specific embodiments.

Comparative Example 2 is the case where only high-frequency waves are introduced, and the moisture and gas barrier properties are inferior compared to the specific embodiments. The fineness of the film is high because a self-bias is generated, but the temperature rise of the container is large and this is believed to generate many minute cracks. Further, the film thickness is small. Because the plasma density is low, the film formation rate is quite low. Accordingly, the productivity is low.

From the above, in the specific embodiments it became possible to provide a manufacturing apparatus and a manufacturing method which form a high-quality film with good productivity, and a plastic container having a DLC film coated on the outer wall surface, wherein a high-frequency capacitive coupling type discharge system and a microwave discharge system were effectively combined to have a mechanism different from the film forming mechanism of each method.

Forming a DLC Film on the Inner Wall Surface of a Plastic Container

Specific Embodiment 6

A DLC film was formed on the inner wall surface of a plastic container using the manufacturing apparatus of Fig. 5 described in the second embodiment, and then evaluations were carried out.

The plastic container used a container (capacity 500ml, 68.5$\phi$ × 207mmH, resin thickness 0.3mm, internal surface area 400cm$^2$) having a bottle shape for beverages which was not equipped with partition plates.

The container material was PET. The source gas used acetylene.

The film forming pressure inside the vacuum chamber was 0.10Torr, the source gas flow rate was 50sccm, the film formation time was 2 seconds, the high-frequency output was 500W, and the microwave output was 500W. The plasma CVD conditions are shown in Table 3.

Specific Embodiment 7

Except for the high-frequency output being 350W, and the microwave output being 600W, Specific Embodiment 7 was made the same way as Specific Embodiment 6.

Specific Embodiment 8

Except for the high-frequency output being 600W, and the microwave output being 250W, Specific Embodiment 8 was made the same way as Specific Embodiment 6. Further, Specific Embodiment 8 is an example in which the high-frequency output is the main output and the microwave output is an auxiliary output in the generation of plasma.

Specific Embodiment 9

Except for the container material being COC, Specific Embodiment 9 was made the same way as Specific Embodiment 6.

Specific Embodiment 10

Except for the container material being PP, Specific Embodiment 10 was made the same way as Specific Embodiment 6.

Comparative Example 6

Except for the high-frequency output being 0W, and the microwave output being 800W, Comparative Example 6 was made the same way as Specific Embodiment 6.

Comparative Example 7

Except for the microwave output being 0W, the high-frequency output being 800W, the source gas flow rate being 150sccm, and the film formation time being 6 seconds, Comparative Example 7 was made the same way as Specific Embodiment 6.

Comparative Example 8

Comparative Example 8 was made a control by not forming a film on a container made of PET.

Comparative Example 9

Comparative Example 9 was made a control by not forming a film on a container made of COC.

Comparative Example 10

Comparative Example 10 was made a control by not forming a film on a container made of PP.

TABLE 3

| | Film Forming Pressure Inside Vacuum Chamber (Torr) | Source Gas Flow Rate (sccm) | Container Material | Film Formation Time (s) | High-Frequency Output (W) | Microwave Output (W) |
|---|---|---|---|---|---|---|
| Specific Embodiment 6 | 0.10 | 50 | PET | 2 | 500 | 500 |
| Specific Embodiment 7 | 0.10 | 50 | PET | 2 | 350 | 600 |
| Specific Embodiment 8 | 0.10 | 50 | PET | 2 | 600 | 250 |
| Specific Embodiment 9 | 0.10 | 50 | COC | 2 | 500 | 500 |

TABLE 3   (continued)

|  | Film Forming Pressure Inside Vacuum Chamber (Torr) | Source Gas Flow Rate (sccm) | Container Material | Film Formation Time (s) | High-Frequency Output (W) | Microwave Output (W) |
|---|---|---|---|---|---|---|
| Specific Embodiment 10 | 0.10 | 50 | PP | 2 | 500 | 500 |
| Comparative Example 6 | 0.10 | 50 | PET | 2 | 0 | 800 |
| Comparative Example 7 | 0.10 | 150 | PET | 6 | 800 | 0 |
| Comparative Example 8 | - | - | PET | - | - | - |
| Comparative Example 9 | - | - | COC | - | - | - |
| Comparative Example 10 | - | - | PP | - | - | - |

The same evaluations as in the case of the containers of Specific Embodiments 1 ~ 5 and Comparative Examples 1 ~ 5 were carried out for the containers of Specific Embodiments 6 ~ 10 and Comparative Examples 6 ~ 10.
The evaluation results are shown in Table 4.

Blank Space Below

TABLE 4

| | Film thickness (Å) | | | Film thick ness Distribution | Container Deformation | Film Formation Rate (Å/s) | Oxygen Permeability (ml/container/ day) | Moisture Permeability (mg/container/ 100 days) |
|---|---|---|---|---|---|---|---|---|
| | Opening Lower Portion | Body Portion | Bottom Portion | | | | | |
| Specific Embodiment 6 | 590 | 600 | 620 | ○ | ○ | 302 | 0.004 | 1110 |
| Specific Embodiment 7 | 620 | 640 | 650 | ○ | ○ | 318 | 0.003 | 980 |
| Specific Embodiment 8 | 510 | 510 | 530 | ○ | ○ | 258 | 0.004 | 1180 |
| Specific Embodiment 9 | 610 | 620 | 640 | ○ | ○ | 312 | 0.006 | 100 |
| Specific Embodiment 10 | 610 | 630 | 640 | ○ | ○ | 313 | 0.142 | 590 |
| Comparative Example 6 | 630 | 680 | 710 | Δ | Δ | 337 | 0.010 | 3820 |
| Comparative Example 7 | 230 | 240 | 250 | ○ | ○ | 40 | 0.009 | 3120 |
| Comparative Example 8 | - | - | - | - | - | - | 0.031 | 6520 |
| Comparative Example 9 | - | - | - | - | - | - | 0.152 | 590 |
| Comparative Example 10 | - | - | - | - | - | - | 0.512 | 1980 |

In the case where a DLC film is formed on the container inner wall surface, and the same tendencies as those in the case where a DLC film is formed on the container outer wall surface were observed.

Namely, in Specific Embodiments 6 ~ 10, because a self-bias is applied, the film thickness distribution is excellent compared with Comparative Example 6 in which a self-bias is not applied.

In Specific Embodiment 6, with both the effect of introducing microwaves and the effect of introducing high-frequency waves, a fine film having high moisture and gas barrier properties was obtained, and it is believed that there were few cracks. However, the high-frequency output is large, and because an etching effect appears, the film formation rate is not the highest in the specific embodiments.

In Specific Embodiment 7, a high-density plasma is formed by microwaves, and because a self-bias voltage is moderately generated due to the introduction of high-frequency waves, a fine film having the most superior moisture and gas barrier properties was obtained, and it is believed that there were very few cracks. Further, because the etching effect is not as strong as that of Specific Embodiment 6, the film formation rate is high.

In Specific Embodiment 8, the system is designed to create a high-density plasma by applying microwaves supplementally under conditions in which a plasma is generated by high-frequency waves and ionic collisions occur due to self-bias. Although not as good as that of Specific Embodiment 6, a high fineness film having superior moisture and gas barrier properties was obtained, and it is believed that there were few cracks.

In Specific Examples 9 and 10, the material of the container was changed, but this had no specific effect, and the same tendencies as those of Specific Embodiment 6 were observed.

Comparative Example 6 is the case where only microwaves are introduced, and at this film thickness, sufficient moisture and gas barrier properties, in particular moisture gas barrier properties were not obtained. The ionized source material is not attracted to the plastic surface, and because ionic collisions are not created, the film is believed to lack fineness. Further, the film formation rate is fast, but the film thickness which makes it possible to secure moisture and gas barrier properties at a prescribed level is believed to be large compared to the other specific embodiments.

Comparative Example 7 is the case where only high-frequency waves are introduced, and the moisture and gas barrier properties are slightly inferior compared to the specific embodiments. The fineness of the film is high because a self-bias is generated, but the temperature rise of the container is large and this is believed to generate many minute cracks. Further, the film thickness is small. Because the plasma density is low, the film formation rate is quite low. Accordingly, the productivity is low.

From the above, even in the case where a DLC film was formed on the container inner wall surface, it became possible to provide an apparatus for manufacturing a DLC film coated plastic container, the container thereof, and a method of manufacturing such container in which a high-quality film with good productivity is formed, wherein a high-frequency capacitive coupling type discharge system and a microwave discharge system were effectively combined to have a mechanism different from the film forming mechanism of each method.

**Claims**

1. An apparatus for manufacturing a DLC film coated plastic container which forms a DLC (Diamond Like Carbon) film on the outer wall surface of said plastic container, comprising:

   a grounded vacuum chamber for housing said plastic container;
   a high-frequency bias electrode which is provided inside said vacuum chamber via an insulating body at a position in contact with the inner wall surface of said plastic container or near said inner wall surface;
   a microwave supply means which generates a source gas plasma inside said vacuum chamber by introducing microwaves inside said vacuum chamber;
   a high-frequency output supply means connected to said high-frequency bias electrode to generate a self-bias voltage at the outer wall surface of said plastic container; and
   a source gas supply means which introduces a source gas inside said vacuum chamber.

2. The apparatus for manufacturing a DLC film coated plastic container described in Claim 1, wherein said high-frequency bias electrode is formed to have an electrode structure which is positioned in contact with the inner wall surfaces of a plastic container equipped with partition plates or near said inner wall surfaces.

3. An apparatus for manufacturing a DLC film coated plastic container which forms a DLC film on the inner wall surface of said plastic container, comprising:

   an external electrode which also serves as a vacuum chamber for housing said plastic container positioned near the outer wall surface of said plastic container;

an internal electrode which is inserted in the opening of said plastic container and is grounded in an insulated state with respect to said external electrode;

a microwave supply means which generates a source gas plasma inside said plastic container by introducing microwaves inside said plastic container;

a high-frequency output supply means connected to said external electrode to generate a self-bias voltage at the inner wall surface of said plastic container; and

a source gas supply means which introduces a source gas inside said plastic container.

4. A method of manufacturing a DLC film coated plastic container in which a DLC film is formed on the outer wall surface of said plastic container, comprising the steps of:

housing said plastic container in a grounded vacuum chamber, and setting a high-frequency bias electrode in an insulated state with respect to said vacuum chamber at a position in contact with the inner wall surface of said plastic container or near said inner wall surface; and then

supplying a source gas inside said vacuum chamber; and

forming a DLC film on the outer wall surface of said plastic container by supplying microwaves inside said vacuum chamber to generate a source gas plasma inside said vacuum chamber, and simultaneously supplying a high-frequency output to said high-frequency bias electrode to generate a self-bias voltage at the outer wall surface of said plastic container.

5. The method of manufacturing a DLC film coated plastic container described in Claim 4, wherein said plastic container is a plastic container equipped with partition plates, and said high-frequency bias electrode is formed to have an electrode structure which is positioned in contact with the inner wall surfaces of said plastic container equipped with said partition plates or near said inner wall surfaces.

6. A method of manufacturing a DLC film coated plastic container in which a DLC film is formed on the inner wall surface of said plastic container, comprising the steps of:

housing said plastic container inside a vacuum chamber so that the outer wall surface of said plastic container is roughly in contact with the inner wall surface of said vacuum chamber, and inserting a grounded internal electrode in an insulated state with respect to said vacuum chamber from the opening of said plastic container; and then

supplying a source gas inside said plastic container; and

forming a DLC film on the inner wall surface of said plastic container by supplying microwaves inside said plastic container to generate a source gas plasma inside said plastic container, and simultaneously supplying a high-frequency output to said vacuum chamber to generate a self-bias voltage at the inner wall surface of said plastic container.

7. A DLC film coated plastic container, wherein a DLC film having moisture and gas barrier properties is formed on the outer wall surface of a plastic container equipped with partition plates.

Fig.1

# Fig.2

61

1

(a)

61

1

(b)

# Fig.3

(a)

(b)

# Fig. 4

( a )

( b )

Fig. 5

<table>
<tr><td colspan="2"><b>INTERNATIONAL SEARCH REPORT</b></td><td>International application No.<br>PCT/JP01/05471</td></tr>
</table>

**A. CLASSIFICATION OF SUBJECT MATTER**
Int.Cl⁷ B65D 1/00, 1/24, B65D25/04, 25/34, C08J 7/06, C23C16/27, C23C16/511

According to International Patent Classification (IPC) or to both national classification and IPC

**B. FIELDS SEARCHED**

Minimum documentation searched (classification system followed by classification symbols)
Int.Cl⁷ B65D 1/00-1/48, B65D25/04-25/08, 25/34, C08J 7/06, C23C16/27, C23C16/511

Documentation searched other than minimum documentation to the extent that such documents are included in the fields searched
Jitsuyo Shinan Koho 1926-1996 Toroku Jitsuyo Shinan Koho 1994-2001
Kokai Jitsuyo Shinan Koho 1971-2001 Jitsuyo Shinan Toroku Koho 1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 11-246974 A (Nissin Electric Co., Ltd.), 14 September, 1999 (14.09.99), & WO 99/45168 & EP 997554 | 1,2,4-7 |
| Y | JP 8-053117 A (Kirin Brewery Company, Limited), 27 February, 1996 (27.02.96), & WO 96/05112 A1 & US 5798139 A & EP 773167 A1 | 3 |
| Y | JP 4-329879 A (Shimadzu Corporation), 18 November, 1992 (18.11.92), (Family: none) | 1-6 |
| Y | JP 2000-51478 A (PepsiCo, Inc., Fujimi Inc.), 05 September, 2000 (05.09.00), & WO 97/44179 A1 & US 5788794 A & GB 2329358 A | 2,5,7 |
| Y | JP 11-106920 A (Nissin Electric Co., Ltd.), 20 April, 1999 (20.04.99), (Family: none) | 7 |

☐ Further documents are listed in the continuation of Box C.    ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 17 September, 2001 (17.09.01) | 09 October, 2001 (09.10.01) |

| Name and mailing address of the ISA/ | Authorized officer |
|---|---|
| Japanese Patent Office | |
| Facsimile No. | Telephone No. |

Form PCT/ISA/210 (second sheet) (July 1992)